# EUROPEAN PATENT APPLICATION

(11) **EP 0 986 044 A2**
(43) Date of publication of application: **15.03.2000**
(21) Application number: 99306953.3
(22) Date of filing: 01.09.1999
(51) Int. Cl.: G09F 13/22

(54) **Display units and components thereof**

(30) Priority: 07.09.1998 JP 29129198; 22.01.1999 JP 1444299
(71) Applicant: Subaru Engineering Co. Ltd., Yokohama-shi, Kanagawa-ken (JP)
(72) Inventor: Shimizu, Hiroshi, c/o Subaru Eng. Co.Ltd., Minami-ku, Yokohama-shi, Kanagawa-ken (JP)
(74) Representative: Swindell & Pearson

(57) **Abstract**

Segments of EL fiber 2 constituting characters to be displayed are fitted with "A" rubber terminals 3, one for each. Core electrode 2b of each segment is inserted entirely through a hole 10a formed in the base panel 10 at a point conforming to the character to be displayed. A "B" rubber terminal 4 is fitted around the portion of the core electrode 2b that has passed through and protruded beyond the base panel 10. The free end portion of the core electrode 2b thus protruded is bent to a direction parallel with the back side of the base panel 10 until it rests in a slit 4c. In this way an outside electrode 2a is brought into contact under pressure with a first conducting member 12a through a conducting rubber 3a, and the core electrode 2b is pressed and contacted with a second conducting member 12b through a conducting rubber 4a, thus establishing a conductive state up to an input terminal 6. The EL fiber segments as linear light sources on the base panel can form characters, patterns, symbols, etc. in a two- or three- dimensional arrangement for display. The used EL fiber segments may serve different duties again and again. The construction is simple and inexpensive and consumes small power for accentuated display of interior decorations, etc. Without the need of soldering, the display unit is safely used, e.g., as teaching aids.

## Description

This invention relates to display units. More particularly, but not exclusively, the invention relates, to display units capable of two- or three-dimensional display of characters, patterns, symbols, etc. for accentuated display of interior decorations and the like.

For the display with linear light sources it has hitherto been customary to use neon tubes, fluorescent indicator tubes and the like arranged or formed to characters, symbols, or other shapes as outdoor advertising signs or accentuated displays of interior decorations. The display units using neon tubes and fluorescent indicator tubes usually depend on domestic or industrial electric sources for power supply, and when it becomes dark the power is supplied to the light sources for lighting and display. More recent displays have employed point sources of light such as miniature bulbs and light-emitting diodes representing characters or symbols or have used display units comprising clear tubes of light-emitting or light-storing resin in which miniature bulbs and LED chips are accommodated at given intervals, so that the entire clear tube looks illuminated when their light sources are switched on.

Meanwhile, U.S. Patent Application No. 08/736021 (filed on October 22, 1996) and the corresponding Japanese Patent Application Kokai No. 10-172755 (laid open to the public on June 26, 1998) proposed a flexible electroluminescence (EL) fiber which consists essentially of a core electrode, an electroluminescent layer (an electroluminescent powder bound to a mass with a clear organic binder) surrounding the core electrode, and an outside electrode of transparent or light-transmitting structure covering the EL layer. The product is now commercially available (marketed under the trade designation "LyTec" by ELAM Co. at Har Hotzvim, Jerusalem, Israel). A dielectric layer may be sandwiched between the core electrode and the electroluminescent layer, and a clear dielectric layer may interpose between the electroluminescent layer and the outside electrode. The clear electrode generally is covered with a protective coating of insulating, clear resin or elastomer. As the outside electrode, the clear electrode may be supplanted by a spiral electrode embedded in a clear, insulating resin. The present invention utilizes a flexible EL fiber of any of the afore-described structures. Such a fiber will be explained below to the extent just necessary for the understanding of the invention, and for other details U.S. Patent Application No. 08/736021 or the corresponding Japanese Patent Application Kokai No. 10-172755 is cited for reference. The fiber according to the cited invention works with low power, has good luminescent quality, and is freely bendable, with its shape and length changeable as desired even after mounting on a base panel. With these features the fiber is by far the more versatile than conventional displays and is advantageously used in a broad range of applications including outdoor and indoor decorations and billboards.

However, the displays using neon tubes and fluorescent indicator tubes are standardized, and free designing is next to impossible. If a display is to be designed as desired, a special order at extra cost becomes necessary. The neon tubes and fluorescent indicator tubes once designed can hardly be reused for a different pattern, and power consumption is large because of the power loss due to the heat development of light sources and transformers and the much current demand by high-luminosity luminescent devices themselves.

The displays depending on point sources of light such as miniature bulbs or LED chips require so many point sources that they are expensive and involves much power consumption. Moreover, the displays once designed are very difficult to reuse or design anew.

The displays using miniature bulbs or LED chips housed in transparent tubing have a problem too. The tubes having so large outside diameters, it is not easy to fabricate them into forms of characters or symbols. Each character or symbol has to be shaped uninterruptedly as if drawn in one stroke.

Further, the flexible EL fiber disclosed in U.S. Patent Application No. 08/736021 or Japanese Patent Application Kokai No. 10-172755 has to be stripped at one end of its insulating covering to expose a core electrode and an outside electrode and join the respective electrodes by soldering to a pair of electrodes provided in a base panel such as a printed circuit board or connect the electrodes to feeder terminals. Low joining efficiency is a disadvantage in either case.

According to one aspect of the invention there is provided a display unit comprising a base panel and at least one linear light source having two electrodes and adapted to emit light, said base panel having a conducting member, at least one electrode of said light source being inserted through a throughhole or slot formed in said base panel, and at least one of said electrodes being electrically connected to said conducting member.

According to another aspect of the invention there is provided a base panel for supporting at least one linear light source to constitute a display unit, comprising a laminate which consists of a first conducting member, at least one second conducting member held opposite to the first conducting member, and dielectric material layers interposed between and over these conducting members, said base panel being formed with a plurality of throughholes or slots.

According to another aspect of the invention there is provided a connecting structure comprising a conductive elastic member having a throughhole or slot formed therein, said member being interposed between a core electrode or outer electrode of a linear light source and a conducting member for power supply and electrically connected thereto.

According to another aspect of the invention there is provided a connecting structure comprising conductive elastic members through which flat, plate-shaped draw-out ends of core electrodes of two linear light sources are connected respectively to outside electrodes of the other linear light sources. According to another aspect of this invention there is provided a display unit comprising a base panel and at least one linear light source having two electrodes and adpated to emit light, said base panel having at least one conducting member, at least one electrode of said light source being inserted through a throughhole or slot formed in said base panel, at least one of said electrodes being electrically connected to said at least one conducting member.

The display units according to preferred embodiments of the present invention have the following compositions.

The invention, in essence, resides in a display unit comprising a base panel and at least one linear light source having two electrodes and adapted to emit light, characterized in that the base panel has at least one conducting member, at least one electrode of the light source is inserted through a throughhole or slot formed in the base panel, and at least one of the electrodes is electrically connected to the at least one conducting member, and also resides in the base panel itself.

The base panel may have a single conducting member but preferably has a first conducting member and at least one second conducting member opposite to the first member. One electrode of the light source may be inserted through a throughhole or slot formed in the base panel and may be electrically connected to either of the first and second conducting members. The other electrode of the light source may be electrically connected on the display side of the base panel to the other one of the first and second conducting members.

The base panel may have a structure in which the conducting member or members are alternately laminated with dielectric members.

The construction of the preferred embodiments makes it easy and simple to connect each linear light source to an electric power source because it is only necessary to insert exposed ends of the core electrode and outside electrode at the end of the linear light source into a throughhole or slot formed in the base panel.

For favorable connection with good workability of the electrodes of each linear light source to each of the conducting members, it is desirable that the conducting member be partly stripped for exposure in the region around the throughhole or slot, and its electrodes are preferably inserted into the throughhole or slot to be electrically connected to the conducting member through a conducting member in contact with the exposed portion, a conductive elastic member, or a contact conducting member consisting of a conductive film.

The above construction permits positive conductive connection easily and with good workability without the need of soldering.

Thus, in the preferred embodiment, forming a hole in the conductive elastic member for the passage of the electrodes of the linear light source facilitates the EL electrode insertion and securing in place.

The linear light source can be secured to the base panel by means of a transparent or semitransparent fixing member having a hook capable of supporting the light source and a snap-fit tongue for insertion into a hole formed in the base panel. The fixing position can be changed by shifting the position of the fixing member on the base panel, and accordingly the characters, patterns, etc. formed by such linear light sources can be changed with ease. The linear light source may be secured at the other end to the base panel by means of a transparent or semitransparent fixing member having a ring closed at one end to receive and support that end of the light source and a snap-fit tongue for insertion into a hole formed in the base panel, whereby the electrodes at the other end of the light source are preferably protected from the atmosphere.

In the preferred embodiments, a connecting structure which effects electrical connection by interposing a conductive elastic member (especially a conductive rubber piece) having a throughhole or slot formed therein between a core electrode or outer electrode of a linear light source and a conducting member for power supply, facilitates the connecting work.

Luminescence in two or more different colors is made possible in the preferred embodiments with two linear light sources of different colors by electrically connecting the draw-out ends of their core electrodes alternately with their outside electrodes through conductive elastic rubber pieces each having a throughhole or slot formed therein as above, and by maintaining the connected state by a retaining means.

An advantage of the preferred embodiment of the invention is that it provides display units which permit characters, patterns, symbols, etc. to be easily formed of linear light sources in a two- or three-dimensional arrangement on a base panel, are capable of reuse the number of times desired, simple in structure and available at low cost and yet can achieve accentuated exhibition of interior decorations with low power consumption, the displays being capable of blinking like neon signs and of safe usage as teaching aids without the need of soldering.

It is another advantage of the preferred embodiment of the invention to provide electrical connector means whereby linear light sources such as flexible EL fiber segments that have a pair of electrodes at one end can easily be mounted on a base panel.

Embodiments of the invention will now be described by way of example only, with reference to the accompanying drawings, in which:-
FIG. 1 is an exploded view showing the construction of a first embodiment of the display unit of the invention;
FIG. 2 is a fragmentary sectional view of the display unit of FIG. 1 as assembled;
FIG. 3 is a fragmentary sectional view of an electrode part of an EL fiber as a linear light source;
FIG. 4 shows "A" and "B" rubber terminals, each in plan view and sectional view across the center;
FIG. 5 shows a hook and a ring as fixing means in central sectional views;
FIG. 6 is an exploded view showing the construction of a second embodiment of the display unit of the invention;
FIG. 7 is a fragmentary sectional view of the display unit of FIG. 6 as assembled;
FIG. 8 is a fragmentary sectional view showing the construction of a third embodiment of the display unit of the invention;
FIG. 9 is a fragmentary sectional view showing the construction of a fourth embodiment of the display unit of the invention;
FIG. 10 is a fragmentary sectional view showing the construction of still another embodiment of the display unit of the invention;
FIG. 11 is a fragmentary sectional view showing the construction of still another embodiment of the display unit of the invention capable of simultaneously illuminating two or more linear light sources;
FIG. 12 is an enlarged sectional view of the essential details of FIG. 11;
FIG. 13 is a front view of yet another embodiment of the invention in which an EL fiber segment has a terminal for connection;
FIG. 14 is a vertical sectional view of the connection structure shown in FIG. 13;
FIG. 15 is a sectional view of two EL fiber segments of different colors connected by the connection means of the embodiment shown in FIGS. 13 and 14; and
FIG. 16 is a sectional view of a further embodiment of the display unit of the invention.

The display unit comprises a base panel including conducting members and one or more linear light sources whose electrodes are inserted through the base panel for contact and conductive connection with the conducting members, the base panel having at least one conducting member, at least one electrode of each light source being inserted through the base panel, and at least one electrode being electrically connected to the conducting member for conduction. Preferably, a contact conducting means is interposed between each normal light source electrode and a conducting member to facilitate and ensure the conduction and connection. Also, preferably, fixing means are provided for securing the light sources to the base panel to allow the light sources to emit light for display purposes.

The base panel has a structure in which the conducting member or members are alternately laminated with dielectric members, and the panel has throughholes or slots for receiving the electrodes of the light sources. The contact conducting means are brought into contact through a conducting member, conductive elastic member, or a conductive film. The conductive elastic member is conductive rubber at least one end of which is covered with a dielectric member and formed with a small hole. The fixing means are made of clear resin, one of the means having a hook and a snap-fit tongue formed in one piece and the other having a ring closed at one end and a snap-fit tongue formed in one piece. Each linear light source is an EL fiber segment.

Thus, in the display unit of the invention, electrodes of EL fiber segments are fitted with rubber terminals and inserted into throughholes or slots or a base panel which includes conducting members, into conductive contact with the conducting members. Characters, patterns, symbols, etc. are formed with EL fiber segments in a two- or three-dimensional arrangement, and the segments are secured to the base panel with hooks and rings as fixing means, and power is supplied to permit the unit to display readily.

Bent portions of the core electrodes of the EL fiber segments thus laid out and inserted through the base panel can be bent back and pulled out of the panel so that the segments can be repeatedly used the number of times desired.

The base panel has dielectric members laid on both the display side and the back side, and rubber terminals on both sides are covered with dielectric members, one for each.

Also, the base panel is provided with a plurality of conducting members so that power can be supplied with a time lag to a plurality of core electrodes of EL fiber segments.

Some embodiments of the invention will now be described in detail with reference to the accompanying drawings.

### First embodiment

A first embodiment of the display unit according to the invention will be described at first.

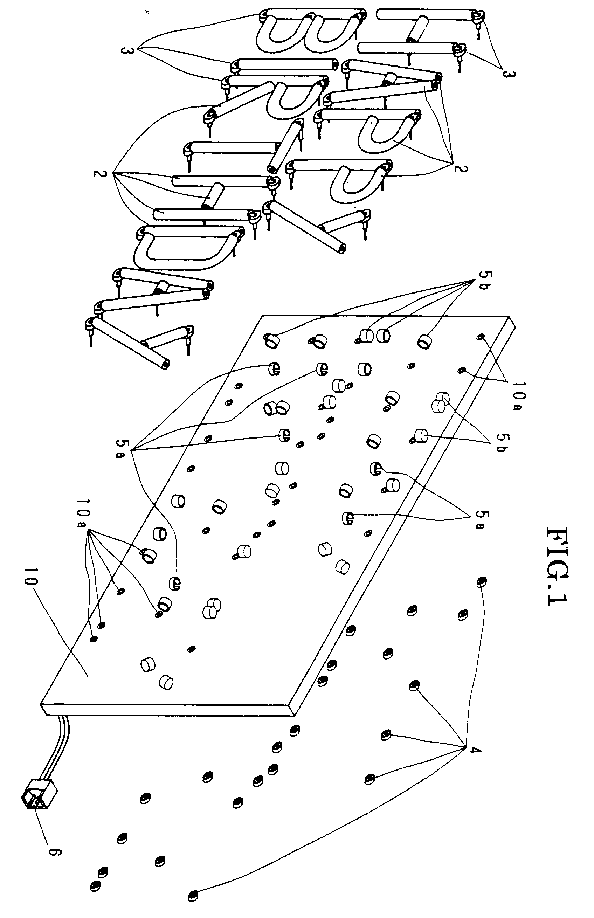

FIG. 1 is an exploded view showing the construction of the first embodiment of the display unit of the invention.

Referring to FIG. 1, the numeral 2 indicates a flexible electroluminescent fiber known in the art as a linear light source, as cut into segments and arranged to form a plurality of characters for display, and 10 indicates a base panel consisting of two parallel sheet-like conductive members sandwiched between dielectric layers, with throughholes or slots 10a formed at points where electrode terminals are drawn out for connection to the ends of EL fiber segments that constitute characters or the like. Designated 3 are "A" rubber terminals each made of conductive and insulating rubber materials, 4 are "B" rubber terminals also made of conductive and insulating rubber materials, 5a are hooks with which the EL fiber segments 2 are secured to the base panel 10, 5b are rings to fix the rear ends of the EL fiber segments to the base panel 10, and 6 is an input terminal for applied voltage. The end portion of each EL fiber segment 2 is worked for electrode connection to expose a core electrode and an outside electrode. The EL fiber segment is cut at its rear end to the length of the character part it represents, and one of the "A" rubber terminals 3 is fitted on its outside electrode. A "B" rubber terminal (not shown) is fitted on its core electrode at the back of the base panel. The base panel 10 has the throughholes or slots 10a at points corresponding to the ends of characters to be displayed. The dielectric members on the display side and the back side are slightly stripped off from around the throughholes or slots 10a to expose the conductive members.

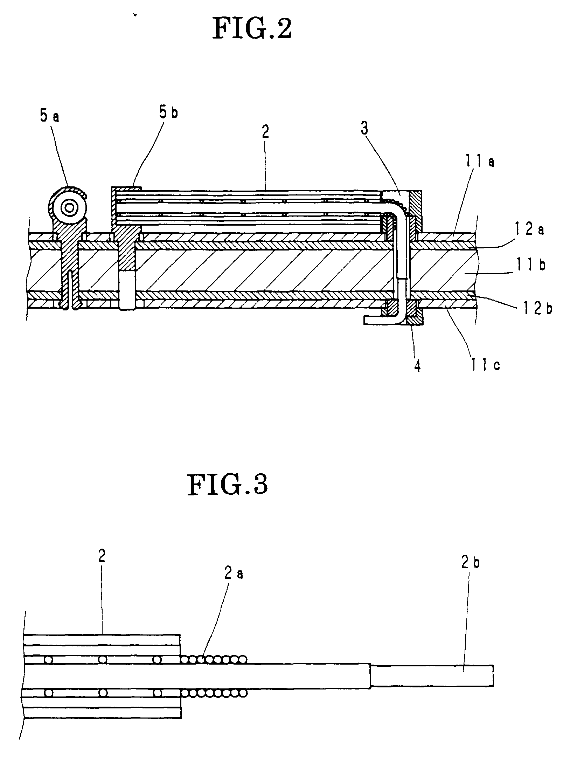

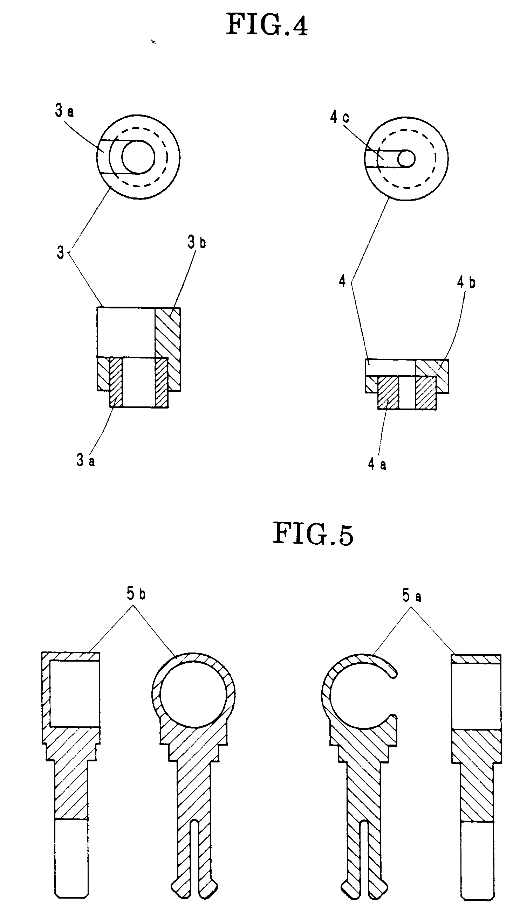

Next, the principle of current passage and the construction of the first embodiment of the display unit whereby light from the light source is emitted will be explained in detail. FIG. 2 is a fragmentary sectional view of the display unit of FIG. 1 as assembled; FIG. 3 is a fragmentary sectional view of an electrode part and draw-out end of an EL fiber; FIG. 4 shows "A" and "B" rubber terminals, each in plan view and sectional view across the center; and FIG. 5 shows a hook and a ring as fixing means, each in front sectional view and central sectional view.

FIG. 3 illustrates an EL fiber 2 of the structure described in U.S. Patent Application No. 08/73608021 and which may be utilized in the present invention. An outside electrode (also called an additional electrode), indicated at 2a, consists of at least one length of conductor wire helically wound at a given pitch with a sufficient space provided to permit the passage of light. The numeral 2b represents a core electrode which is an electrode of the EL fiber 2. Between these electrodes is interposed an electroluminescence layer, and an insulating coating is formed over the outside electrode 2a. At one end of the EL fiber 2, both the insulating coating and the electroluminescent layer are partly stripped so that the core electrode 2b and the additional electrode 2a are axially staggered and exposed for the purpose of electrical connection. To ensure good connection the additional electrode 2a is finished with tighter winding as shown.

As illustrated in FIG. 2, the base panel 10 has a laminated, double-decker structure in which a first dielectric member 11a on the display side and a second dielectric member 11b on the inner side sandwich a first conductive member 12a in between while the second dielectric member lla and a third dielectric member llc on the back side sandwich a second conductive member 12b. It has throughholes or slots formed, as stated above, at points where the connecting ends of the EL fiber segments 2 are to be located. For the conduction from the input terminal 6 to the first conducting member 12a the latter is pulled out to the back side to form a contact end as one terminal portion, and for the conduction from the input terminal 6 to the second conducting member 12b the third dielectric member 11c on the back side is partly stripped to provide another terminal portion. The input terminal 6 is connected to the respective terminal portions.

As FIG. 4 shows, each "A" rubber terminal 3 is formed integrally of conductive rubber 3a and insulating rubber 3b. The conductive rubber 3a has a small hole in the center and the insulating rubber 3b has a groove 3c to accommodate the portion of the EL fiber 2 inward of the outside electrode 2a. Similarly, the "B" rubber terminal 4 is made integrally of conductive rubber 4a and insulating rubber 4b, and the conductive rubber 4a has a small hole in the center and the insulating rubber 4b has a slit 4c to receive the core electrode 2b of the EL fiber 2. The insulating terminals 3b, 4b, after having been mounted on the base panel 10, serve to insulate the conductive rubbers 3a, 4a and electrodes 2a, 2b from the outside.

As is clear from FIG. 5, two kinds of fixing members are used to fix the EL fiber segments to the surface of the base panel 10. One is made of a clear resin forming a hook 5a to receive and support the outer periphery of the EL fiber, in one piece with a bifurcated snap-fit tongue for insertion into a throughhole or slot formed in the base panel. The other fixing member too is made of a clear resin and has a similar engaging tongue formed in one piece with a ring 5b which supports one end of the EL fiber and is itself closed at one end to protect the end of the EL fiber against the intrusion of moisture and foreign matter into the electrodes of the fiber.

In assembling the unit, as shown in FIG. 2, the components so far described are handled in the following way. An "A" rubber terminal 3 is fitted around the additional electrode 2a of each segment of EL fiber 2 corresponding to a character to be displayed. The core electrode 2b of the segment is inserted entirely through a throughhole or slot 10a formed in the base panel 10 at a point conforming to the character to be displayed. A "B" rubber terminal 4 is fitted around the portion of the core electrode 2b that has passed through and protruded beyond the base panel 10. The free end portion of the core electrode 2b thus protruded is bent midway to a direction parallel with the back side of the base panel 10 until the bent portion rests in the slit 4c. In this way the outside electrode 2a is brought into contact under pressure with the first conducting member 12a through the conducting rubber 3a, and the core electrode 2b is pressed and contacted with the second conducting member 12b through the conducting rubber 4a, thus establishing a conductive state up to the input terminal 6. In the same fashion all the segments are arranged on the display side of the base panel 10 in conformity with the characters to be displayed and are held in parallel with the base surface with their roots bent to fit in the slits 3c, while the opposite, rootless ends are capped with the rings 5b of the fixing members and are fixedly secured as the engaging tongues of the fixing members are inserted into corresponding throughholes or slots 10a of the base panel 10. Depending on the lengths and curves of the characters they represent, the segments may further be secured in place with the hooks 5a that are inserted at their tongues into the base panel.

In the manner described the characters to be displayed are made up. Power supply from the source via the input terminal 6 readily permits them to light up or flash on and off for display. Since the display is made possible by conduction through contact, no soldering is required.

The use of rubber terminals ensures perfect electrical connection and precludes defective luminescence of the EL fiber which might otherwise result from improper contact.

Very good working property makes efficient assembling possible.

A further advantage is the ease of replacement and adjustment of once assembled EL fiber units.

### Second embodiment

Now a second embodiment of the display unit of the invention will be described.

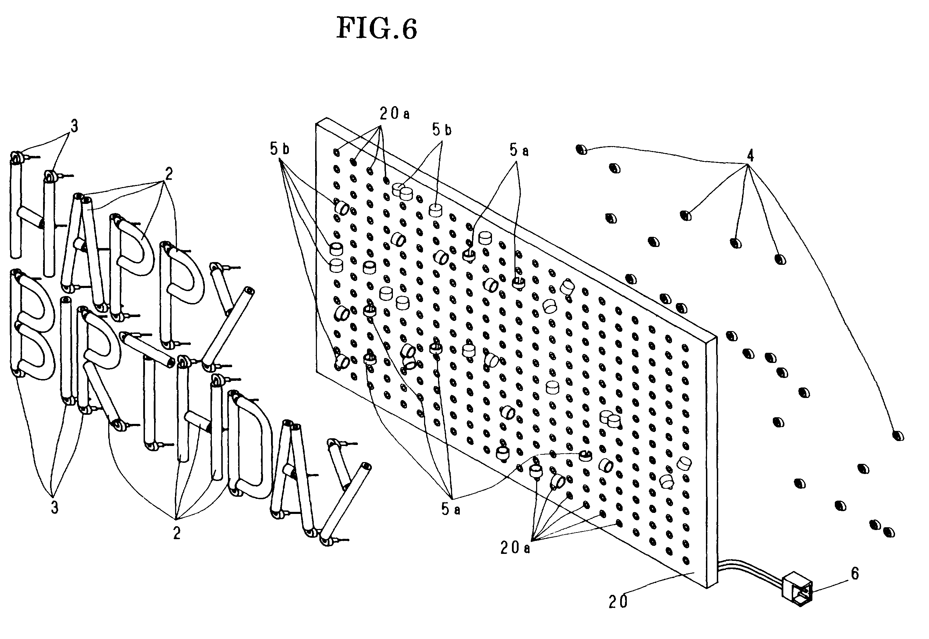

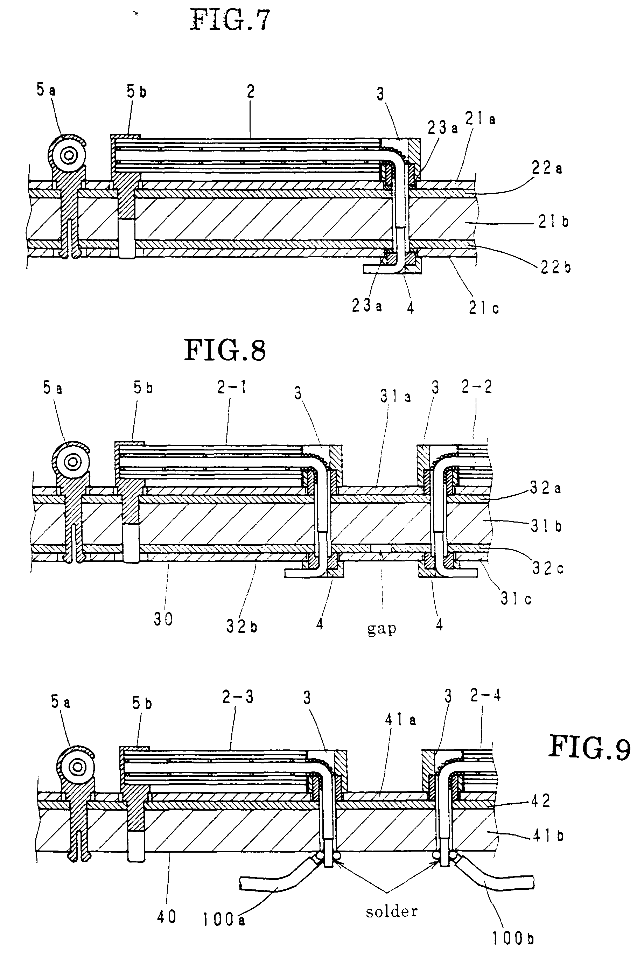

FIG. 6 is an exploded view like FIG. 1 but showing the construction of the second embodiment of the display unit of the invention, and FIG. 7 is a fragmentary sectional view of the display unit of FIG. 6 as assembled.

Referring to FIGS. 6 and 7, the display unit as the second embodiment includes a base panel 20 formed with a plurality of equally spaced throughholes or slots 20a. The dielectric members on the display and back sides are slightly removed around the throughholes or slots 20a to expose the conducting members beneath. Conductive film 23a is formed on the exposed surfaces of the first conducting member 22a and the second conducting member 23a. The remainder of the construction is the same as that of the first embodiment and the description is omitted.

The second embodiment described above provides, in addition to the effects of the first embodiment, the following features. Each of the segments of EL fiber 2 constituting the characters to be displayed can be easily lighted or blinked for display by the insertion of its core electrode 2b into a given one of the plurality of throughholes or slots in the base panel 20, from the display side to the back side, and bending of the protruding portion of the core electrode 2b through a "B" rubber terminal 4 to a direction parallel with the back side. The segments of EL fiber 2 can be pulled off from the base panel 20 by straightening the bent portion of the core electrode 2b at the back of the base panel 20 and removing the "B" rubber terminal 4 from the core electrode. Thus they can be repeatedly used for two- or three-dimensional layout of other characters, image patterns, symbols, etc. Should any core electrode 2b be broken during repeated use, light emission would be possible by finishing the particular segment end to expose the inner core electrode portion. The segments of EL fiber 2 are capable of repeated service as long as their luminescent layer and electrodes are present.

The first and second embodiments of the invention shown in FIGS. 1 and 6, respectively, may appear to use combinations of ready-made alphabets, or of segments preformed to the characters to be displayed. Actually, the individual segments of EL fiber 2 are worked to expose their electrodes at ends and are cut to varied lengths, yet to be fitted with "A" rubber terminals. The hooks 5a and rings 5b are not inserted into the base panels 10 and 20; they are inserted in place when the segments have been laid out to match the characters, symbols, etc. to be displayed.

### Third embodiment

Now a third embodiment of the display unit according to the present invention will be described.

FIG. 8 is a fragmentary sectional view corresponding to FIG. 2 and showing the construction of the display unit as the third embodiment.

Referring to FIG. 8, the base panel 30 of the third embodiment consists of a first dielectric member 31a on the display side and a second dielectric member 31b sandwiching a first conducting member 32a in between, and a second conducting member 32b and a third conducting member 32c sandwiched between the second dielectric member 31b and a third dielectric member 31c. Character segments 2-1 and 2-2 of EL fiber 2 have additional electrodes both of which are in contact, via "A" rubber terminals 3, with the first conducting member 32a for conduction. Their core electrodes are inserted through the base panel 30, with the free end portions conductively connected, via "B" rubber terminals 4, with the second and third conducting members 32b, 32c, respectively. The rest of the construction is the same as that of the first embodiment and the description is not reiterated.

The third embodiment thus far described has, besides the effects of the first embodiment, the following feature. The character segments 2-1 and 2-2 can be lighted on and off like neon lights with power applied from different sources with a predetermined time lag, because the second and third conducting members 32b and 32c to which the core electrodes of the segments are conductively connected are held apart by a space and serve as separate electrodes.

### Fourth embodiment

A fourth embodiment of the display unit according to the present invention will be described below.

FIG. 9 is a fragmentary sectional view corresponding to FIG. 2 and showing the construction of the display unit as the fourth embodiment.

Referring to FIG. 9, the base panel 40 of the fourth embodiment is a sandwich consisting of a first dielectric member 41a on the display side, a second dielectric member 41b on the back side, and a conducting member 42 as the interlayer. Additional electrodes of character segments 2-3 and 2-4 of EL fiber 2 are in conductive contact with the conducting member 42 in common, through "A" rubber terminals 3. Core electrodes of the segments are inserted through the base panel 40, and their projecting ends are connected with lead wires 100a and 100b, respectively, with solder. The remainder of the construction is the same as that of the first embodiment and the description is omitted.

The fourth embodiment so far described requires only one conducting member 42 for the base panel 40, and the both core electrodes 2a-3 and 2a-4 are connected, respectively, with lead wires 100a and 100b with solder. Application of power with a time lag to those lead wires allows the segments to blink like neon lights. If the both lead wires are conductively connected and supplied with power, the segments can work in the same manner as the counterparts of the first embodiment.

### Fifth embodiment

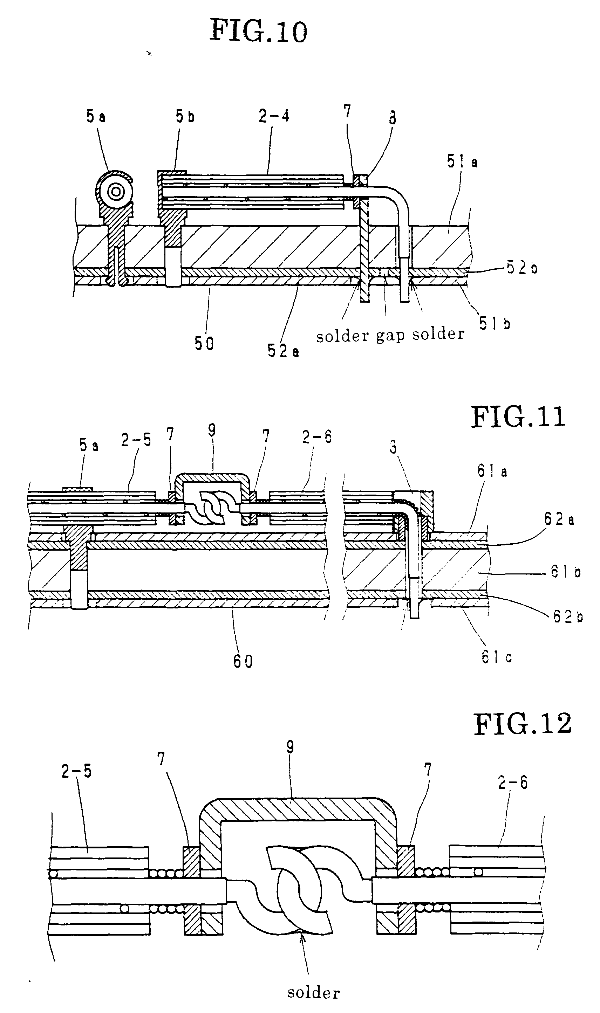

FIG. 10 illustrates an embodiment of the invention having an EL fiber core electrode connected in the usual manner to an electrode member of a base panel with solder while the outside electrode of the EL fiber segment is connected in place using a connector means according to the invention.

The base panel is made up of two conducting members 52a and 52b space apart and sandwiched between two dielectric member layers 51a and 51b. A conducting member 8 is held vertically through the base panel. The conducting member 8 is fitly inserted through a hole formed in the panel and its lower end is joined to the conducting member 52a with solder. A ring-shaped rubber terminal 7 of conductive rubber has a throughhole or slit large enough to fit in contact with a portion of a character segment 2-7 of EL fiber from which the additional electrode has been partly removed. The other side of the rubber terminal 7 is in contact with the conducting member 8. The core electrode is directly joined to the conducting member 52b with solder. Description of the remainder of the construction, which is the same as that of the first embodiment, is omitted.

The fifth embodiment uses the conductive rubber terminal 7 which permits electrical connection of the additional electrode and the conducting member 8 without relying upon soldering. The rubber terminal 7 makes sure of the dependable electrical connection between the additional electrode and conducting member 8 which would otherwise be impossible.

### Sixth embodiment

There is shown in FIGS. 11 and 12 another embodiment in which two linear light sources of different colors are connected for simultaneous light emission. In this embodiment the base panel has a double-decker structure consisting of two conducting members 62a and 62b sandwiched between dielectric members 61a, 61b, and 61c. Using an "A" rubber terminal 3 the additional electrode at one end of a first-color character segment 2-6 of EL fiber is connected to the conducting member 62a in the manner illustrated in FIG. 9, while one end of the core electrode of the character segment 2-6 is extended through the base panel and joined to the conducting member 62b with solder. The opposite end portion of the core electrode is stripped and led into the space inside an inverted-U-shaped conducting member 9, where it is curved to a hook shape and engaged and soldered together with a similarly curved end portion of the core electrode of a second-color character segment 2-5 in the same space inside the inverted-U-shaped conducting member 9. Meanwhile the ends of the additional electrodes of these character segments are stripped and electrically connected to the conducting member 9 by means of two ring-shaped rubber terminals 7 of the structure already described in conjunction with FIG. 10.

As embodied here, the invention makes it possible with ease to build a set of linear light sources of different colors for simultaneous illumination, by use of the rubber terminals 7.

### Seventh embodiment

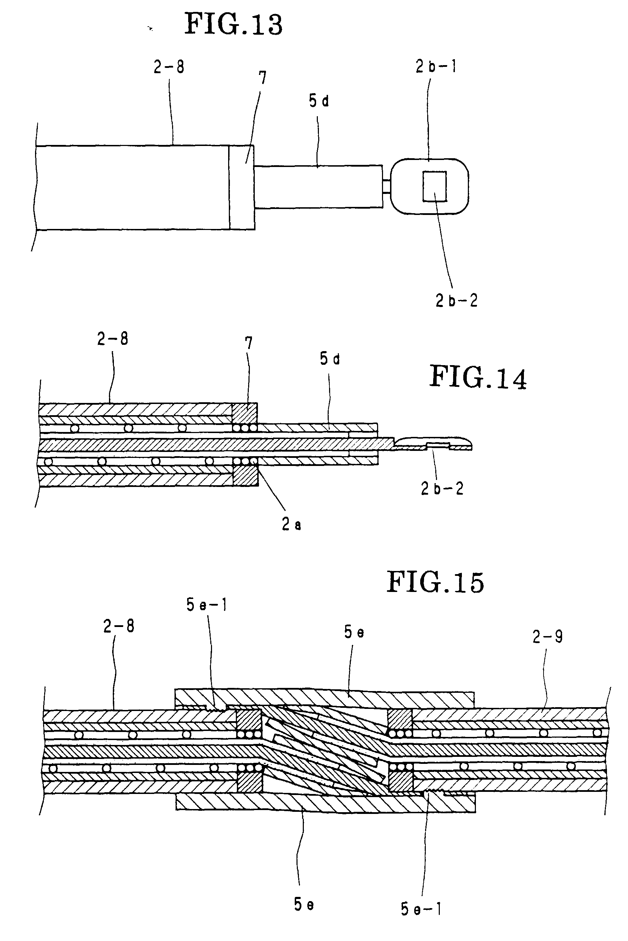

FIGS. 13 to 15 shows still another embodiment of the invention in which two or a given number of linear light sources that emit different colors each are connected by means of elastic terminals, or specifically ring-shaped rubber terminals.

As in FIGS. 13 and 14, a linear source for emitting a certain colored light, or an EL fiber segment 2-8 is stripped at one end for electrode exposure in the manner illustrated in FIG. 3. A rubber terminal 7 is mounted and an insulating tube 5d is fitted, and the free end of the core electrode is worked to form a flat, plate-shaped terminal 2b-1 as shown. The end portion of this EL fiber segment is superposed with a similarly worked end portion of another EL fiber segment 2-9 of a different color through rubber terminals as shown in FIG. 15. The superposed end portions are securely covered with an insulating resin sleeve 5e. To ensure solid joining, the terminals 2b-1 have an opening 2b-2 each and the sleeve 5e has claws or inward projections 5e-1 adapted to engage with the openings.

### Eighth embodiment

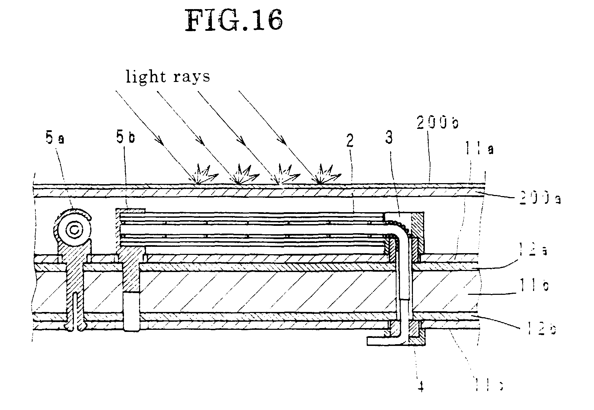

FIG. 16 is a fragmentary sectional view showing the construction of yet another embodiment of the display unit of the invention. This embodiment uses a protective cover and a sheet to protect a linear light source against deterioration and discoloration with ultraviolet rays and also to prevent the reflection of external light by the glossy surface of an EL fiber segment itself.

The numeral 200a designates a protective cover and 200b, a protective sheet. The protective cover 200a guards the display unit and the protective sheet 200b allows the EL fiber segment to maintain its color stably and cuts off reflection of external light to permit display with clear contrast with the surroundings.

While preferred embodiments of the invention have been described, it is to be understood that changes and variations may be made without departing from the spirit or scope of the invention.

For example, the segments representing a character or characters to be displayed may vary in color that they emit, or they may be replaced by a single segment for display.

For the fixing purpose, cords or adhesive may be used as substitutes for the hooks 5a and rings 5b. As a further alternative, the terminating ends of segments may be bent integrally into the base panel.

The "A" and "B" rubber terminals may be supplanted by coil springs or leaf springs. Also, elasticity of resin or conductive adhesive may be utilized for conduction.

The core electrode 2 may be joined to a conducting member or lead wire by soldering.

The mode of display may be steady lighting, blinking, intermittent lighting, or a combination of those modes.

It is further possible to insulate the rubber terminals by partial coating with an insulating resin instead of using insulating rubber on the terminals.

As has been described above, according to the invention, electroluminescence is achieved upon power supply to a display unit by simply inserting the electrodes of EL fiber segments, fitted with rubber terminals, into throughholes or slots formed in a base panel which includes conducting members and by bending the projecting ends of the core electrodes for conductive connection with the base panel. It is also easy to light such a unit steadily or on and off like neon signs by properly choosing a plurality of throughholes or slots formed in the base panel for EL fiber segments and fixing the segments in the form of characters, patterns, symbols, etc. in a two- or three-dimensional arrangement to the base panel. The used EL fiber segments may serve different duties again and again only if their bent core electrodes are bent back to the original shape. The base panel, with dielectric members disposed on both sides and with rubber terminals covered with insulating members, can safely be used without the danger of electric shock. The construction is simple and inexpensive and consumes small enough power to operate with ordinary batteries. Without the need of soldering, the display unit is revolutionary for various uses, e.g., as teaching aids to everybody. Electrical connection is possible without the base panel but with conducting members and rubber terminals alone. The connection structure according to the invention renders it simple to connect linear light sources of different colors for multicolor display.

Whilst endeavouring in the foregoing specification to draw attention to those features of the invention believed to be of particular importance it should be understood that the Applicant claims protection in respect of any patentable feature or combination of features hereinbefore referred to and/or shown in the drawings whether or not particular emphasis has been placed thereon.

## Claims

1. A display unit comprising a base panel and at least one linear light source having two electrodes and adapted to emit light, said base panel having a conducting member, at least one electrode of said light source being inserted through a throughhole or slot formed in said base panel, and at least one of said electrodes being electrically connected to said conducting member.

2. A display unit according to claim 1 wherein said base panel has a first conducting member and at least one second conducting member opposite to the first member, one electrode of said light source is inserted through a throughhole or slot formed in the base panel and is electrically connected to either of said first and second conducting members and the other electrode of said light source is electrically connected on the display side of the base panel to the other one of said first and second conducting members.

3. A display unit according to claim 1 or 2 wherein said base panel has a structure in which the or each conducting member is alternately laminated with dielectric members.

4. A display unit according to claim 1, 2 or 3 wherein the or each conducting member is partly stripped for exposure in the region around said throughhole or slot, and said electrodes inserted into said throughhole or slot are electrically connected to said conducting member through a conducting member in contact with said exposed portion, a conductive elastic member, or a contact conducting member consisting of a conductive film.

5. A display unit according to claim 4 wherein said conductive elastic member has a hole through which the electrodes of said linear light source are passed.

6. A display unit according to any preceding claim wherein said linear light source is secured to said base panel by means of a transparent fixing member having a hook capable of supporting the light source and a snap-fit tongue for insertion into a hole formed in the base panel.

7. A display unit according to any of claims 1 to 5 wherein said linear light source is secured to said base panel by means of a transparent fixing member having a ring closed at one end to receive and support one end of the light source and a snap-fit tongue for insertion into a hole formed in the base panel.

8. A display unit according to any preceding claim wherein said light source is an electroluminescence fiber.

9. A display unit according to any preceding claim wherein the surface of the base panel on which linear light sources are disposed is protected with a transparent protective cover against ultraviolet light.

10. A base panel for supporting at least one linear light source to constitute a display unit, comprising a laminate which consists of a first conducting member, at least one second conducting member held opposite to the first conducting member, and dielectric material layers interposed between and over these conducting members, said base panel being formed with a plurality of throughholes or slots.

11. A base panel according to claim 10 wherein said conducting members are partly stripped in the regions around the both open ends of the throughhole or slot at the point where said light source is secured, the base panel further comprising at least one contact conducting member having a conducting part in contact with the exposed regions and a hole formed in the conducting part for the insertion of the electrodes of said light source.

12. A base panel according to claim 11 wherein the contact conducting member is a conductive elastic member.

13. A base panel according to claim 10, 11 or 12 which further comprises transparent or semitransparent fixing members each having a hook for supporting the light source and a snap-fit tongue for insertion into a hole formed in the base panel.

14. A base panel according to claim 10, 11 or 12 which further comprises transparent or semitransparent fixing members each having a ring closed at one end so that it can receive and support one end of the light source and a snap-fit tongue for insertion into a hole formed in the base panel.

15. A connecting structure comprising a conductive elastic member having a throughhole or slot formed therein, said member being interposed between a core electrode or outer electrode of a linear light source and a conducting member for power supply and electrically connected thereto.

16. A connecting structure according to claim 15 wherein said elastic member is a conductive rubber ring.

17. A connecting structure comprising conductive elastic members through which flat, plate-shaped draw-out ends of core electrodes of two linear light sources are connected respectively to outside electrodes of the other linear light sources.

18. A connecting structure according to claim 17 wherein the draw-out ends are securely held together by a retaining sleeve.

19. A connecting structure according to claim 18 wherein the draw-out ends have an engaging opening each and the retaining sleeve has claws or inward projections adapted to engage with the openings.
